(19) Europäisches Patentamt

European Patent Office

Office européen des brevets

(11) **EP 0 948 129 B1**

(12) **EUROPEAN PATENT SPECIFICATION**

(45) Date of publication and mention
of the grant of the patent:
**26.01.2005 Bulletin 2005/04**

(51) Int Cl.⁷: **H03D 7/18**, H03D 7/16

(21) Application number: **98200992.0**

(22) Date of filing: **30.03.1998**

(54) **RF image reject mixer for a radio receiver.**

Mischer mit Unterdrückung der Spiegelfrequenzen für einen Rundfunkempfänger

Mélangeur à réjection de fréquence image pour un récepteur de radio

(84) Designated Contracting States:
**BE DE DK ES FI FR GB GR IT SE**

(43) Date of publication of application:
**06.10.1999 Bulletin 1999/40**

(73) Proprietor: **Telefonaktiebolaget LM Ericsson (publ)**
**164 83 Stockholm (SE)**

(72) Inventor: **Essink, Berend Hendrik**
**7546 LK Enschede (NL)**

(74) Representative:
**Dohmen, Johannes Maria Gerardus et al**
**Algemeen Octrooi- en Merkenbureau**
**P.O. Box 645**
**5600 AP Eindhoven (NL)**

(56) References cited:
**EP-A- 0 185 416          EP-A- 0 782 249**
**EP-A- 0 797 292**

• **CROLS J ET AL: "A SINGLE-CHIP 900 MHZ CMOS RECEIVER FRONT-END WITH A HIGH PERFORMANCE LOW-IF TOPOLOGY" IEEE JOURNAL OF SOLID-STATE CIRCUITS, vol. 30, no. 12, 1 December 1995, pages 1483-1492, XP000557254**

**Description**

<u>Field of the Invention</u>

The present invention relates to telecommunication systems and, more specifically, to equipment for receiving radio communication signals.

<u>Background of the Invention</u>

In modern radio receivers, such as designed for the well-known cellular GSM (Global System for Mobile communication) and DECT (Digital Enhanced Cordless Telecommunications), for example, generally two different receiver architectures are used.

In digital direct-conversion or zero-IF (Intermediate Frequency) radio receivers analogue RF (Radio Frequency) signals are down-converted to base band and digitized for processing in the digital domain. Receiver selectivity is mainly established in the digital domain.

In a single or dual conversion and a single or double superheterodyne receiver, signals in the RF transmission band are down converted to a relatively high first IF and selectively filtered in a pass-band centered around the first IF, typically 110 MHz for DECT. In a next conversion step, the filtered signal is further down converted to a second IF, typically 10 MHz, for further processing of the signals received. With this radio architecture, selectivity is mainly achieved by using a so-called SAW (Surface Acoustic Wave) band-pass filter at the first IF.

The zero-IF concept requires a dedicated digital back-end to be developed, using analogue-to-digital converters and digital signal processing, while there is a DC (Direct Current) offset that has to be cancelled.

The superheterodyne receiver with a relatively high first IF is rather costly and bulky in design, due to the off-chip SAW filter. The SAW filter contributes significantly to the total costs, space and power requirements of a radio receiver.

Savings in components space, manufacturing costs and power consumption are important design criteria in modern wireless telecommunication receiver equipment. For single chip integrated receivers, i.e. receivers completely integrated on a single silicon chip, the costs are mainly determined by the required silicon area. For integration of the single or dual conversion or single and double superheterodyne receiver architectures at a single silicon chip, integrated band-pass filters are required. At present, such filters can be only effectively produced for a relatively low frequency (e.g. 3 MHz). However, to be able to use such type of filters, an image reject mixer is required having sufficient rejection of image frequencies which, at such a low IF, are within the RF transmission band of the radio communication system.

Image frequencies are those frequencies which, in addition to the tuned or desired frequency, also provide an output at the selected IF of an RF mixer.

European patent application 0 782 249 discloses an image reject mixer for a radio receiver, comprising first mixer means for down conversion of an RF input signal providing first quadrature signals at a low first IF, such that image frequencies are within the RF transmission band of a radio communication system.

The low pass filtered first quadrature signals are then up-converted to second quadrature signals at a second IF above the first IF by second mixer means. The second IF is selected at a frequency at which high performance, passive filters are available for providing the required selectivity, typically 10 MHz.

It can be shown that the second quadrature signals produced by the second mixer means have spectra such that the signal components representing the signal of interest are in phase but the components representing image signals of the second mixer are 180° out of phase. Accordingly, if the second quadrature signals are summed, the result is simply the signal of interest.

In practice, due to imperfections of the circuit components, i.e. component tolerances, unbalances, temperature etc., usually an image rejection of about 20-30 dB is achieved. For a practically required rejection of 50 dB, in particular at a second IF < 10 MHz, e.g. 4 MHz, relatively sharp cut off or low pass filters of a relatively high order, i.e. 5 or more, are needed to suppress the image frequency of the second mixer means to achieve the required rejection ratio at the output thereof. Those skilled in the art will appreciate that such low pass filters, in terms of group delay and magnitude, present a significant distortion of the required signal.

European patent application 0 185 416 discloses a radio transceiver having first and second mixer means. The first mixer means are arranged for down-conversion of an RF input signal and the second mixer means are arranged for up-conversion of the down-converted input signal, using the same local oscillator frequency for both conversions. Image rejection is provided by a feedback loop from the output of the second mixer means to the input of the first mixer means.

Summary of the Invention

It is an object of the present invention to provide an image reject mixer for a radio receiver having an improved image frequency rejection.

It is a further object of the present invention to provide an image reject mixer operating at a relatively low first and second IF providing a required rejection ratio while avoiding the need for high order low pass filters.

It is in particular an object of the present invention to provide a receiver, comprising the improved image reject mixer, for use in modern wireless telecommunication systems such as GSM, DECT and other known mobile and cordless telecommunication equipment, inclusive wireless Local Area Networks.

Starting from European patent application 0 185 416, according to the present invention, there is provided an image reject mixer for a radio receiver for operation in a Radio Frequency (RF) transmission band, comprising first mixer means arranged for operating at a first local oscillator frequency for down conversion of an RF input signal providing first quadrature signals ($I_{IF1}$, $Q_{IF1}$) centered at a first intermediate frequency (IF1) and such that image frequencies of the first mixer means are within the RF transmission band, and second mixer means for up-conversion of the first quadrature signals providing second quadrature signals ($I_{IF2}$, $Q_{IF2}$) centered at a second intermediate frequency (IF2) above the first intermediate frequency (IF1), and polyphase filter means operatively arranged between the first and second mixer means for providing filtered first quadrature signals for up-conversion by the second mixer means, characterized in that the second mixer means are arranged for operating at a second local oscillator frequency, the first and second local oscillator frequencies being separately selectable.

In the context of the present invention, the term polyphase filter means indicates a class of filter means which ideally provide quadrature output signals for quadrature input signals having a phase difference of +90° at the frequency to which the polyphase filter means are tuned, and zero output for quadrature input signals having a phase difference of -90° at the frequency to which the polyphase filter means are tuned.

It can be shown that, due to the -90° phase difference of the first quadrature signals at the image frequency of the second mixer means, the polyphase filter means, tuned to the image frequency of the second mixer means, will effectively cancel that image frequency at the input of the second mixer means.

With the arrangement according to the invention, theoretically, low pass filters between the first and second mixer means are eliminated.

In practice, however, the image rejection provided by the arrangement according to the present invention is also influenced by component spreading and offsets. Accordingly, in a further embodiment of the invention, for obtaining an optimum image rejection, additional low pass filtering is provided of the quadrature signals input to the polyphase filter means. However, these low pass filter means can be of a relatively low order, anyhow lower than used in the prior art image reject mixer, discussed above. Thereby eliminating the inherent distortion (magnitude and group delay) of the required signal due to the relatively high order of such low pass filters for obtaining a desired image frequency rejection in practical circuit design.

The image reject mixer according to the present invention is advantageously used in a radio communication system wherein the RF transmission band comprises a plurality of adjacent transmission channels spaced at a channel spacing distance, wherein the first intermediate frequency (IF1) of the first mixer means is selected in that its image reject frequencies are within the channel spacing distance adjacent to a selected channel.

In radio telecommunication systems, such as GSM and DECT, the interference ratios required by adjacent transmission channels are less than the interference ratios between transmission channels spaced further apart in the RF transmission band.

In a preferred embodiment of the image reject mixer according to the present invention, the first intermediate frequency (IF1) is selected such that its image frequencies are substantially at the channel spacing distance. With a second intermediate frequency (IF2) at half the channel spacing distance above the frequency of Local Oscillator (LO) means of the second mixer means, the polyphase filter means are tuned at a frequency substantially equal to twice the frequency of the second LO means plus half the channel spacing distance.

The polyphase filter means used in the present invention advantageously may comprise a balanced RC network of the type to be integrated on a single silicon chip, i.e. comprising passive circuit components and/or active circuit elements like Field Effect Transistors (FET's) operated as resistive and capacitive elements, for example. With such active elements an auto-tunable or auto-controllable image reject mixer according to the present invention can be provided.

The invention further provides a receiver for operating in an RF transmission band, comprising an image reject mixer of the type according to the present invention. The first mixer means of the image reject mixer may comprise tunable Local Oscillator (LO) means. The receiver can be manufactured on a single semiconductor chip, in particular a Complementary Metal Oxide Semiconductor (CMOS) or a Bipolar CMOS (BiCMOS) semiconductor chip.

The receiver according to the present invention is in particular suitable for implementation in a radio communication unit such as a radio telephone for operation in a GSM or DECT radio communication system, or the like, comprising transceiver means, timing and synchronisation control means and information and signalling processing means. The first and second intermediate frequencies can be selected at a relatively low sub-rate of the system frequency.

A radio communication unit comprising the receiver according to the present invention benefits from the increased image rejection ratio, less signal distortion and the lower costs of the receiver, e.g. compared to receivers having an SAW filter for obtaining the required selectivity, and smaller size of the unit. A completely integrated cordless radio can be provided with the present invention, which is a very important commercial and design issue for low-end residential cordless consumer products.

The above-mentioned and other features and advantages of the invention are now illustrated in the following description with reference to the enclosed drawings.

Brief Description of the Drawings

Fig. 1 shows a block diagram of a prior art image reject mixer, comprising first and second mixer arrangements.
Fig. 2 shows, in a schematic and illustrative manner, the DECT receive and transmit time slot signal structure.
Fig. 3 shows a block diagram of an image reject mixer according to the present invention.
Fig. 4 shows a further embodiment of an image reject mixer according to the present invention, for low IF frequencies.
Fig. 5 shows a circuit diagram of a pior art polyphase filter for use with the present invention.
Fig. 6 shows a simplified block diagram of a radio communication unit, in particular a DECT radio communication unit, taking the form of a radio telephone set having a receiver comprising an image reject mixer according to the present invention.

Detailed Description of the Embodiments

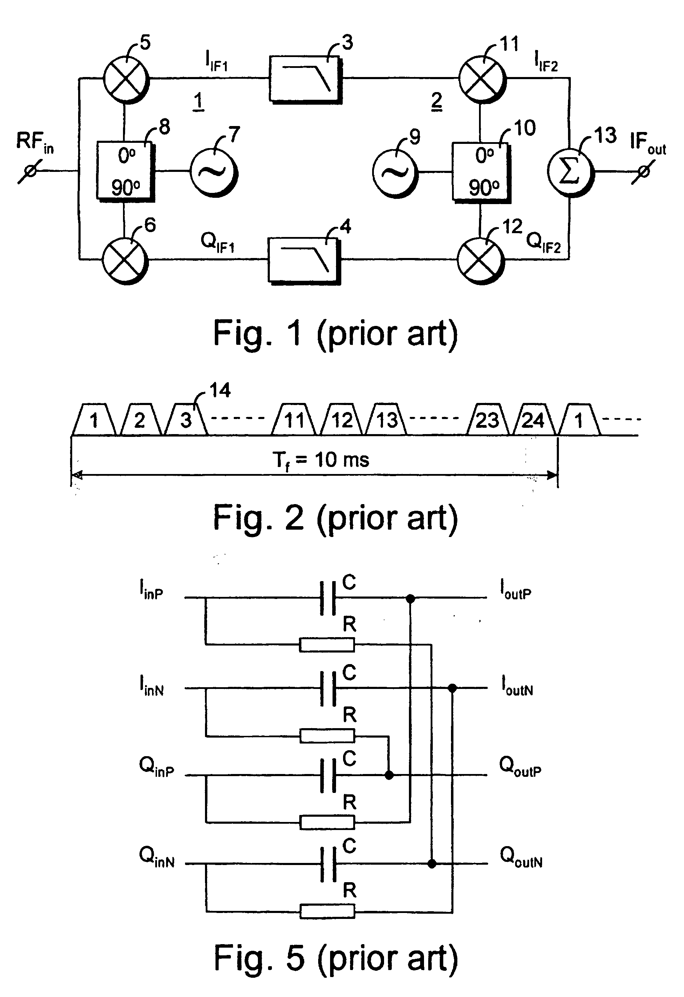

Fig. 1 shows a prior art image reject mixer for a radio receiver for operation in a Radio Frequency (RF) transmission band comprising a cascade connection of first mixer means 1 and second mixer means 2. Between the first and second mixer means low pass filter means 3, 4 are arranged.

The first mixer means 1 comprise a first mixer circuit 5 and a second mixer circuit 6, at a first input of which radio signals $RF_{in}$ at an RF transmission band of a radio communication system are received. The radio signals $RF_{in}$ may be fed to the first and second mixer circuits 5, 6 via an antenna, receive/transmit switch means and Low Noise Amplifier (LNA) means (not shown).

A second input of the first and second mixer circuits 5, 6 connects to a first Local Oscillator (LO) 7. Through 90°-phase shifter means 8 the first LO 7 provides two 90°-phase shifted frequency signals which are fed to the first and second mixer circuits 5, 6, respectively. Those skilled in the art will appreciate that the 90°-phase shifted frequency signals may be provided by a single oscillator providing two substantially 90°-phase shifted output signals of the same signal frequency, instead of an oscillator producing a single frequency signal.

The first mixer means 1 provide quadrature output signals $I_{IF1}$, $Q_{IF1}$ at the outputs of the first and second mixer circuits 5, 6, respectively.

The second mixer means 2 essentially comprise the same circuit components as the first mixer means 1, i.e. third and fourth mixer circuits 11, 12, a second input of which connects to phase shifter means 10 providing 90°-phase shifted output signals at a frequency provided by a second Local Oscillator (LO) 9. The second mixer means 2 produce second quadrature output signals $I_{IF2}$ and $Q_{IF2}$ at the outputs of the third and fourth mixer circuits 11, 12, respectively. The second quadrature signals $I_{IF2}$, $Q_{IF2}$ are processed by means 13, e.g. summation means, to obtain a single output signal $IF_2$ at an output of the processing means 13.

The input signals of the third and fourth mixer circuits 11, 12 are the first quadrature signals outputted by the first mixer means after low pass filtering by the low pass filters 3 and 4.

The circuit of figure 1 is also known as the third method of generation and detection of single-sideband signals by Donald K. Weaver, disclosed in Proceedings of the IRE 1956, pp. 1703-1705, which is herein incorporated by reference.

For the purpose of the present invention, the operation of the circuit of figure 1 will be clarified, for illustrative purposes only, in connection with a radio communication system such the Digital Enhanced Cordless Telecommunications (DECT) radio communication system.

DECT is a Multi Carrier/Time Division Multiple Access/Time Division Duplex (MC/TDMA/TDD) digital radio access technique, providing ten radio carriers, each divided into 24 time-slots 14 which serve 12 duplex communication channels, called a frame, such as illustratively shown in figure 2.

The ten RF carriers allocated to DECT are defined by:

$$F_c = F_0 - c*\text{channel spacing} = F_0 - c*1728 \text{ kHz} \qquad (1)$$

wherein:

$F_0$ = 1897,344 MHz and
c = 0,1,...., 9.

Including guard space, the total number of bits per time slots according to the DECT standard amounts 480. These bits are transmitted at a system clock frequency or system bit rate of 1152 kb/s, resulting in a frame cycle time $T_f$ of 10 ms. From (1) it follows that the RF transmission band for DECT is in the range of 20 MHz.

With reference to the circuit of fig. 1, assume that the first LO 7 is tuned to a frequency such that signals at $RF_{in}$ are converted to a frequency centered at half the channel spacing, i.e. for DECT 864 kHz:

$$\omega_{LO1} = \omega_{RFin} (+ \text{ or } -)(\tfrac{1}{2} \omega_{chan})$$

wherein:

$\omega_{LO1}$ = frequency first local oscillator
$\omega_{RFin}$ = frequency input signal at $RF_{in}$
$\omega_{chan}$ = channel spacing frequency.

The second LO 9 is at a frequency, such that the down converted signals of the first mixer means 1 are upconverted to a desired output Intermediate Frequency (IF) for further processing, in general a frequency substantially at 10 MHz. This, because for this frequency filter means are readily available and at relatively low costs.
For the calculation below, the following assumptions are made:

Frequency first LO:

$$\omega_{LO1} = \omega_{RFin(tuned)} - \tfrac{1}{2}\omega_{chan} \qquad (2)$$

Frequency first quadrature signals:

$$\omega_{IF1} = \omega_{RF} - \omega_{LO1} \qquad (3)$$

Frequency second LO: $\omega_{LO2}$
Second intermediate frequency IF2:

$$\omega_{IF2} = \tfrac{1}{2}\omega_{chan} + \omega_{LO2} \qquad (4)$$

Input signal at $RF_{in}$: $\sin(\omega_{RF}.t)$
LO signal at mixer 5: $\sin(\omega_{LO1}.t)$
LO signal at mixer 6: $\cos(\omega_{LO1}.t)$
LO signal at mixer 11: $\sin(\omega_{LO2}.t)$
LO signal at mixer 12: $\cos(\omega_{LO2}.t)$

With the above assumptions, the In-phase component of the first quadrature signal $I_{IF1}$ at the output of mixer circuit 5 can be expressed as:

$$I_{IF1} = \sin(\omega_{RF}.t) \sin(\omega_{LO1}.t)$$

$$= \tfrac{1}{2}\cos((\omega_{RF} - \omega_{LO1})t) - \tfrac{1}{2}\cos((\omega_{RF} + \omega_{LO1})t) \qquad (5)$$

The Quadrature-phase component $Q_{IF1}$ at the output of the second mixer circuit 6 can be likewise expressed as:

$$Q_{IF1} = \sin(\omega_{RF}.t)\cos(\omega_{LO1}.t)$$

$$= \tfrac{1}{2}\sin((\omega_{RF} - \omega_{LO1})t) + \tfrac{1}{2}\sin((\omega_{RF} + \omega_{LO1})t) \qquad (6)$$

The terms consisting of $\omega_{RF} + \omega_{LO1}$ in equations (5) and (6) are high frequency components which will be very well filtered by the low pass filters 3, 4.

For the second quadrature signals $I_{IF2}$, $Q_{IF2}$ at the outputs of the third and fourth mixer circuits 11, 12 respectively, two different cases have to be identified.

Firstly, it is assumed $\omega_{RF} > \omega_{LO1}$.

From the filtered $I_{IF1}$ signal, i.e. the first part of equation (5), it can be derived that:

$$I_{IF2} = \tfrac{1}{2}\cos((\omega_{RF} - \omega_{LO1})t)\sin(\omega_{LO2}.t) =$$

$$\tfrac{1}{4}\sin((\omega_{RF} - \omega_{LO1} + \omega_{LO2})t) - \tfrac{1}{4}\sin((\omega_{RF} - \omega_{LO1} - \omega_{LO2})t) \qquad (7)$$

Likewise, from the low pass filtered $Q_{IF1}$ signal, i.e. the first part of expression (6), it can be derived that:

$$Q_{IF2} = \tfrac{1}{2}\sin((\omega_{RF} - \omega_{LO1})t)\cos(\omega_{LO2}.t) =$$

$$\tfrac{1}{4}\sin((\omega_{RF} - \omega_{LO1} + \omega_{LO2})t) + \tfrac{1}{4}\sin((\omega_{RF} - \omega_{LO1} - \omega_{LO2})t) \qquad (8)$$

Those skilled in the art will appreciate that equations (5)-(8) have been derived using known trigonometric functions.

By adding the second quadrature signals $I_{IF2}$ and $Q_{IF2}$ as expressed by (7) and (8), the signal $IF_{out}$ at the output of the summation means 13 results in:

$$IF_{out} = \tfrac{1}{2}\sin((\omega_{RF} - \omega_{LO1} + \omega_{LO2})t) \qquad (9)$$

wherein for signals at the second intermediate frequency $\omega_{IF2} = \omega_{RF} - \omega_{LO1} + \omega_{LO2}$ can be rewritten as $\omega_{RF} = \omega_{RF(tuned)}$ using (2) and (4) above. Accordingly, the tuned frequency results in an output signal at IF2 at the output of the mixer.

The terms $\tfrac{1}{4}\sin((\omega_{RF} - \omega_{LO1} - \omega_{LO2})t)$ in equations (7) and (8) theoretically cancel each other. However, in practice, due to component spreadings, temperature and other imperfections of the circuit components a full cancellation will not be achieved. Accordingly, these terms will result in a spurious signal at the frequency: $\omega_{RF} - \omega_{LO1} - \omega_{LO2}$ which, with (2) and (4), can be rewritten as: $\omega_{RF} = \omega_{RF(tuned)} + 2\omega_{LO2}$ providing an output signal at IF2. RF input signals at this frequency result in first quadrature signals at the inputs of the filters 3 and 4 which, from (3) and (4), have a frequency of:

$$\omega_{IF1} = 2\omega_{LO2} + \tfrac{1}{2}\omega_{chan} \qquad (10)$$

Secondly, it is assumed that $\omega_{RF} < \omega_{LO1}$.

With the known trigonometric relationship $\cos(-\alpha) = \cos(\alpha)$ and $\sin(-\alpha) = -\sin(\alpha)$ the filtered first quadrature signals of expressions (5) and (6) lead to second quadrature signals $I_{IF2}$ and $Q_{IF2}$ respectively provided by expressions (11) and (12).

$$I_{IF2} = \tfrac{1}{2}\cos((\omega_{LO1} - \omega_{RF})t) \sin(\omega_{LO2}.t) =$$

$$\tfrac{1}{4}\sin((\omega_{LO1} - \omega_{RF} + \omega_{LO2})t) - \tfrac{1}{4}\sin((\omega_{LO1} - \omega_{RF} - \omega_{LO2})t) \tag{11}$$

$$Q_{IF2} = -\tfrac{1}{2}\sin((\omega_{LO1} - \omega_{RF})t) \cos(\omega_{LO2}.t) =$$

$$-\tfrac{1}{4}\sin((\omega_{LO1} - \omega_{RF} + \omega_{LO2})t) - \tfrac{1}{4}\sin((\omega_{LO1} - \omega_{RF} - \omega_{LO2})t) \tag{12}$$

Addition of these signals by the addition means 13 results in a signal at the $IF_{out}$ output:

$$IF_{out} = -\tfrac{1}{2}\sin((\omega_{LO1} - \omega_{RF} - \omega_{LO2})t) \tag{13}$$

The $RF_{in}$ frequency causing a signal at IF2 is $\omega_{IF2} = \omega_{LO1} - \omega_{RF} - \omega_{LO2}$ and from (2) and (4):

$$\omega_{RF} = \omega_{RF(tuned)} - \omega_{chan} - 2\omega_{LO2} \tag{14}$$

This is an undesired signal that has to be rejected by the low pass filters 3, 4 and with $\omega_{IF1} = \omega_{LO1} - \omega_{RF}$ ($\omega_{RF} < \omega_{LO1}$) from (3) results in first quadrature signals of the frequency:

$$\omega_{IF1} = 2\omega_{LO2} + \tfrac{1}{2}\omega_{chan} \tag{15}$$

which is the image frequency of the second mixer means 2.

The terms $\tfrac{1}{4}\sin((\omega_{LO1} - \omega_{RF} + \omega_{LO2})t)$ in equations (11) and (12) theoretically cancel eachother. However, in practice cancellation will not be completely. Accordingly, these terms will result in a signal at the output of the mixer means. From (2) and (4) it can be established that the $RF_{in}$ frequency causing such a (rejected) signal at IF2 is:

$$\omega_{RF} = \omega_{RF(tuned)} - \omega_{chan} \tag{16}$$

This is the first adjacent channel below the tuned channel. However, the image rejection obtained is usually sufficient due to the limited rejection requirements for the adjacent channel in radio telecommunication systems such as DECT and GSM, for example.

If a relatively low second intermediate frequency IF2 is to be used, e.g. IF2 $\approx$ 4MHz, frequencies around $\omega_{IF1} = \tfrac{1}{2}\omega_{chan}$ have to pass the low pass filters 3, 4 with as less as possible distortion, whereas frequencies at $\omega_{IF1} = 2\omega_{LO2} + \tfrac{1}{2}\omega_{chan}$ (15) have to be sufficiently rejected by the low pass filters, i.e. 50 dB or more. Signals at this frequency may be caused by transmissions in the RF transmission band of the system at a distance from the tuned channel.

For DECT, for example, the low pass filters 3, 4 have to pass the desired signal between 288 kHz and 1.44 MHz, i.e. the pass-band of 1152 kHz of a DECT channel around an IF1 of 864 kHz.

With a second IF of 4.32 MHz, for example, from equation (15) and the bandwidth of 1152 kHz for DECT, it can be calculated that the low pass filters 3, 4 have to reject a spurious signal between 7.2 and 8.352 MHz. Accordingly, low pass filters 3, 4 having an order of 5 or more are needed to achieve an image rejection of 50 dB, which is required for a reliable operation under DECT. Such low pass filters, however, distort the desired signal significantly with respect to group delay and magnitude of the signals passing the filters.

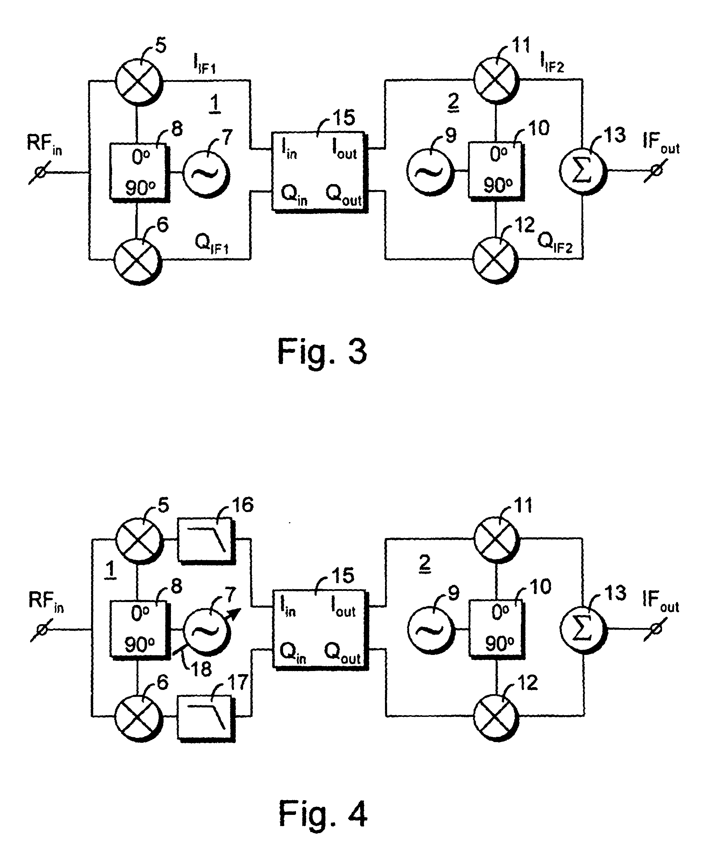

Fig. 3 shows the image reject mixer according to the present invention, wherein between the first mixer means 1 and the second mixer means 2, polyphase filter means 15 are arranged.

The polyphase filter means 15 have input terminals $I_{in}$ and $Q_{in}$ for receiving quadrature input signals and output terminals $I_{out}$ and $Q_{out}$ providing quadrature output signals.

In the present patent application, the term polyphase filter means is used for a class of quadrature filter means providing quadrature output signals for quadrature input signals having a phase difference of +90° while providing zero output for quadrature input signals having a phase difference between the I and Q components of -90°.

It can be shown that an $RF_{in}$ signal having a frequency $\omega_{RF}$ according to equation (14), will have a phase difference of -90° between the first quadrature signals $I_{IF1}$ and $Q_{IF1}$ at the frequency $\omega_{IF1} = 2\omega_{LO2} + \tfrac{1}{2}\omega_{chan}$ (15), i.e.

the image frequency of the second mixer means 2. This can be easily verified by substitution of equation (15) in equations (5) and (6). However, at the required frequency $\omega_{RF} = \omega_{RF(tuned)}$, providing a required output signal at the $IF_{out}$ output of the mixer according to the present invention, the first quadrature signals $I_{IF1}$ and $Q_{IF1}$ have a phase difference of $+90°$ at the frequency $\omega_{IF1} = 2\omega_{LO2} + \frac{1}{2}\omega_{chan}$ (15).

Accordingly, by using polyphase filter means 15 according to the present invention, a signal at the frequency of equation (15), will be effectively rejected by the polyphase filter means 15, whereas the desired frequency will pass and results in quadrature output signals $I_{out}$ and $Q_{out}$ at the output of the polyphase filter means 15. Accordingly, for rejection of a (spurious) signal at the frequency provided by equation (15), i.e. the image frequency of the second mixer means 2, no high order low pass filter means 3, 4 are required, such as disclosed above for the prior art solution.

Due to imperfections and component spreading, however, in practice the polyphase filter means 15 will not completely reject the spurious signal. Practical rejection values of 30 to 40 dB are feasible for a polyphase filter.

Accordingly, in order to obtain a required image rejection of 50 dB at a second intermediate frequency IF2 of 4.32 MHz, for example, in a further embodiment of the mixer according to the present invention shown in fig. 4, the first quadrature signals $I_{IF1}$ and $Q_{IF1}$ are additionally filtered, say by 10-20 dB, e.g. by low pass filters 16, 17 of the second or third order, to obtain the full 50 dB of image rejection.

Those skilled in the art will appreciate that low pass filters of this order will have a less distortion effect on the first quadrature signals compared to low pass filters of the order of 5 or more.

In DECT, an IF2 of 4.32 MHz is obtained with a second LO 9 at a frequency of 3.456 MHz which equals 1/4 of the system clock frequency of 13.824 MHz (X-tal). At such sub-rate frequency quadrature signals are advantageously produced. Those skilled in the art will appreciate that for other systems IF derived from sub-rates of the particular system clock frequency can be advantageously chosen.

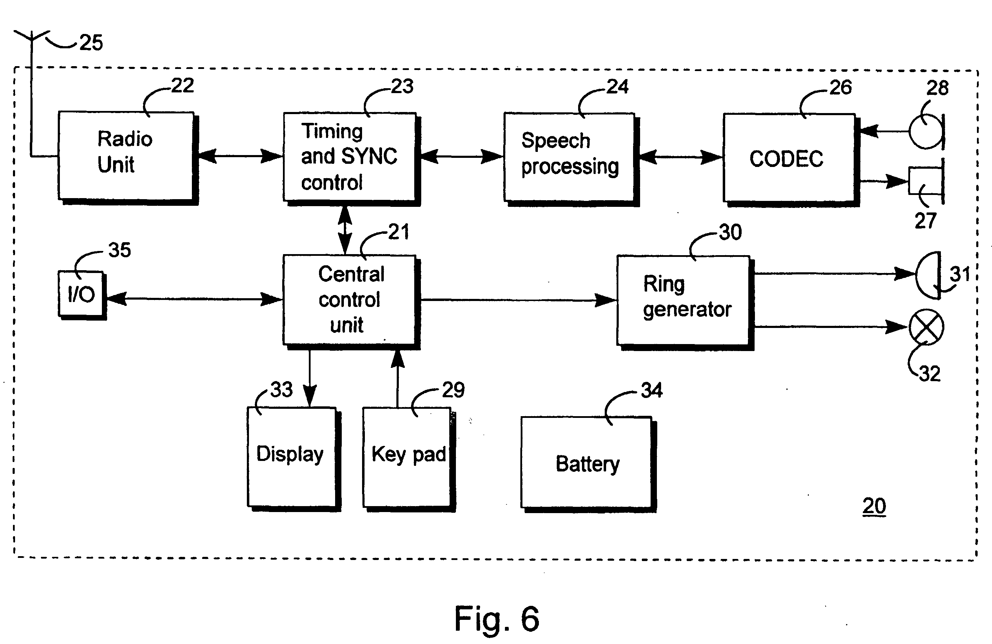

Fig. 5 shows an embodiment of polyphase filter means, comprising a balanced RC network, such as to be used with quadrature input signals in balanced mixer circuitry.

In fig. 5, $I_{inP}$ and $I_{inN}$ are respectively the positive and negative In-phase inputs. $Q_{inP}$ and $Q_{inN}$ are the positive and negative quadrature-phase inputs, respectively. Accordingly, $I_{outP}$ and $I_{outN}$ are the positive and negative I-outputs and $Q_{outp}$ and $Q_{outN}$ are the positive and negative Q-outputs, respectively.

From basic electrical circuit calculations, it can be derived that

$$V_{Iout} = \frac{V_{Qin} + j\omega RCV_{Iin}}{1 + j\omega RC} \tag{17}$$

$$V_{Qout} = \frac{j\omega RCV_{Qin} - V_{Iin}}{1 + j\omega RC} \tag{18}$$

wherein $V_{Iout}$ and $V_{Qout}$ are the output signals of the polyphase filter means.

If $w = \frac{1}{RC}$ both equations (17) and (18) can be rewritten as (19) and (20) respectively:

$$V_{Iout} = \frac{V_{Qin} + jV_{Iin}}{1 + j} \tag{19}$$

$$V_{Qout} = \frac{jV_{Qin} - V_{Iin}}{1 + j} \tag{20}$$

In case of the desired frequency, the phase difference between I and Q will be $+90°$, such that $V_{Qin} = jV_{in}$. Substitution thereof in (19) and (20) leads to

$$V_{Iout} = \frac{2j}{1 + j} V_{Iin} \tag{21}$$

$$V_{Qout} = \frac{-2}{1 + j} V_{Iin} \tag{22}$$

which are quadrature output signals.

In case of an image frequency the phase difference between I and Q will be $-90°$, such that $V_{Qin} = -jV_{in}$.

Substitution thereof in (19) and (20) leads to $V_{Iout}$ = 0 and $V_{Qout}$ = 0. Accordingly, the image is rejected.

In the example above, the polyphase filter means have to be tuned to the frequency $\omega_{IF1}$ = $2\omega_{LO2}$ + $\frac{1}{2}\omega_{chan}$ , such that $\frac{1}{RC}$ = $2\omega_{LO2}$ + $\frac{1}{2}\omega_{chan}$, i.e. the image frequency of the second mixer means.

The image reject mixer according to the present invention provides the opportunity to use a relatively low first IF frequency, and a second IF frequency derived from a local oscillator operating at a sub-rate of the system clock or timing rate, required for on-chip selectivity filters, resulting in lower costs and smaller size radios. Accordingly, completely integrated radios for GSM, DECT, etc. can be build from radio Application Specific Integrated Circuits (ASICs) using available CMOS or BiCMOS semiconductor processes. Such manufacturing processes are known to those skilled in the art, and no further implementation details have to be provided.

Instead of the single polyphase filter means disclosed in figure 5, for the purpose of the present invention a multiple of polyphase filters connected in cascade and/or other filter designs can be used providing, at the tuned frequency, quadrature output signals for quadrature input signals of which the I and Q component have a phase difference of +90° and zero output signals for I and Q quadrature input signals having a phase difference of -90°. The passive circuit components R and C may be provided by active circuit elements such as Field Effect Transistors (FET's) operated as resistive elements and/or capacitive elements, the gate-source junction of which providing a capacitance. So-called varicap diodes may also be used as electrically tunable capacitances. Using either one or both of such elements, a completely, electronically tunable or controlled image reject mixer according to the present invention can be provided. Further band-pass filters 16, 17 may be used instead of the low pass filters shown and discussed.

For tuning of a receiver at a particular carrier frequency, the LO 7 of the first mixer stage is of a tunable type, schematically indicated by an arrow 18 in fig. 4.

Fig. 6 shows a simplified block diagram of a DECT radio telephone set comprising receiver circuitry according to the present invention. The radio telephone set 20 has four essential building blocks, i.e. a central control and application logic unit 21, a radio unit 22, a timing and synchronisation control unit 23 and a speech processing unit 24.

The radio unit 22 comprises an air interface 25 having an antenna system coupled to a transceiver unit comprising a transmitter/modulator and a receiver/demodulator according to the invention.

The timing an synchronisation control unit 23 receives data over the air interface 25 and the radio unit 22 from a base station, which data are processed in accordance with a system clock timing provided by a radio exchange. Signalling and synchronisation information are removed from the received data by the unit 23 and received speech data are fed to the speech processing unit 24. The speech processing unit 24, among others, takes care of the deciphering of received data. A codec 26 decodes the received digitised speech data into a form for making it audible to a user of the handset via a loudspeaker 27 connected to the codec 26.

Speech produced by the user is received by a microphone 28 and encoded into a suitable digital format by the codec 26. This encoded speech data is fed to the speech processing unit 24 which, among others, takes care of encryption of the speech data. The timing and synchronisation control unit 23 adds suitable synchronisation and signalling information to the encrypted speech data. The radio unit 22 transmits this signalling and speech data via the air interface 25 for reception by a radio access unit or base station of the communication system to which the telephone set 20 operatively connects.

The central control and application logic unit 21 comprises a microprocessor or microcontroller and memory means, and connects to the timing and synchronisation control unit 23. The central control unit 21 essentially controls the system data and the communication with the user of the radio telephone set 20 via a keypad means 29, display means 33 and ring generator means 30, all connected to the central control unit 21. Further, and external interface 35 connects to the central control unit 21 for external control and data processing purposes. Frame and time slot allocation and, in the case of a multi-carrier multi-time-slot technology such as DECT, also the various combinations of carrier frequencies and time-slots are controlled by the central control unit 31 and stored in the memory means.

The ring generator means 30 connect to a buzzer 31 for producing a ringing or alerting sound at the arrival of a call. Optionally a visual alerting signal may be emitted by a lamp or Light Emitting Diode (LED) 32, connected as shown. The display means 33, such as an LCD device, are operatively connected to the central control unit 21 for displaying call information and other user and system data.

For the overall powering of the telephone set 20 a battery and powering unit 34 is included.

Although the present invention is generally illustrated with respect to a DECT radio telephone communication system, it is not restricted thereto. The present invention can be used with other TDMA communication systems such as operating in accordance with the GSM (Global System for Mobile communication), PHS (Personal Handyphone System), wireless LAN's, etc.

**Claims**

**1.** An image reject mixer for a radio receiver for operation in a Radio Frequency (RF) transmission band, said image reject mixer comprising first mixer means (1) arranged for operating at a first local oscillator frequency ($\omega_{LO1}$) for down conversion of an RF input signal providing first quadrature signals ($I_{IF1}$, $Q_{IF1}$) centered at a first intermediate frequency (IF1) and such that image frequencies of said first mixer means are within said RF transmission band, and second mixer means (2) for up-conversion of said first quadrature signals providing second quadrature signals ($I_{IF2}$, $Q_{IF2}$) centered at a second intermediate frequency (IF2) above said first intermediate frequency (IF1), and polyphase filter means (15) operatively arranged between said first and second mixer means (1; 2) for providing filtered first quadrature signals for up-conversion by said second mixer means (2), **characterized in that** said second mixer means (2) are arranged for operating at a second local oscillator frequency ($\omega_{LO2}$), said first and second local oscillator frequencies ($\omega_{LO1}$; $\omega_{LO2}$) being separately selectable.

2. An image reject mixer according to claim 1, wherein said polyphase filter means (15) are tuned at an image frequency of said second mixer means (2).

3. An image reject mixer according to claim 1 or 2, wherein said RF transmission band comprises a plurality of adjacent transmission channels spaced at a channel spacing distance, wherein said first intermediate frequency (IF1) of said first mixer means (1) is selected such that said image frequencies of said first mixer means (1) are within the channel spacing distance adjacent to a selected channel.

4. An image reject mixer according to claim 3, wherein said first intermediate frequency (IF1) is selected in that said image frequencies are substantially at the channel spacing distance.

5. An image reject mixer according to claim 4, wherein said polyphase filter means (15) are tuned at a frequency substantially equal to twice the second local oscillator frequency ($\omega_{LO2}$) of said second mixer means (2) plus half the channel spacing frequency distance.

6. An image reject mixer according to any of the previous claims, comprising filter means (16, 17) operatively arranged between said first mixer means (1) and said polyphase filter means (15), for filtering of said first quadrature signals ($I_{IF1}$, $Q_{IF1}$).

7. An image reject mixer according to claim 6, wherein said filter means (16, 17) are low pass filter means having an order less than 5.

8. An image reject mixer according to any of the previous claims, wherein said polyphase filter means (15) comprise a balanced RC network.

9. An image reject mixer according to claim 8, wherein said RC network comprises active circuit elements operated in a resistive and/or capacitive mode.

10. An image reject mixer according to claim 9, wherein said circuit elements are electronically tunable, providing an auto-tunable or auto-controllable mixer circuit.

11. Receiver for operating in a Radio Frequency (RF) transmission band, said receiver comprising an image reject mixer according to any of the claims 1-10.

12. Receiver according to claim 11, wherein said first mixer means (1) comprise a tunable first local oscillator (18).

13. Receiver according to claim 11 or 12, manufactured on a single semiconductor chip, in particular a Complementary Metal Oxide Semiconductor (CMOS) or a Bipolar CMOS (BiCMOS) semiconductor chip.

14. A radio communication unit (20), in particular a radio telephone for operation in a radio communication system such as DECT (Digital Enhanced Cordless Telecommunications) or GSM (Global System for Mobile communications) comprising transceiver means (22), timing and synchronisation control means (23) and information and signalling processing means (21, 24, 26-35), wherein said transceiver means (22) comprise a receiver according to any of the claims 11, 12 or 13.

**Patentansprüche**

1.  Mischer zur Unterdrückung der Spiegelfrequenz für einen Funkempfänger zum Betrieb in einem Funkfrequenz (RF)-Übertragungsband, wobei der Mischer zur Unterdrückung der Spiegelfrequenz erste Mischer (1) enthält, welche zum Betrieb bei einer ersten Lokaloszillatorfrequenz ($\omega_{LO1}$) zum Herunter-Wandeln von einem RF-Eingangssignal, welches erste Quadratursignale ($I_{IF1}$, $Q_{IF1}$) bereitstellt, welche auf einer ersten Mittenfrequenz (IF1) zentriert sind, angeordnet sind, und zwar derart, dass Spiegelfrequenzen der ersten Mischer innerhalb des RF-Übertragungsbandes sind, und zweite Mischer (2), zum Hoch-Wandeln der ersten Quadratursignale, welches zweite Quadratursignale ($I_{IF2}$, $Q_{IF2}$) bereitstellt, welche auf einer zweiten Mittenfrequenz (IF2) oberhalb der ersten Mittenfrequenz (IF1) zentriert sind, und Mehrphasen-Filter (15) enthält, welche wirksam zwischen den ersten und zweiten Mischern (1; 2) angeordnet sind, und zwar zum Bereitstellen von gefilterten ersten Quadratursignalen zum Hoch-Wandeln durch die zweiten Mischer (2), **dadurch gekennzeichnet, dass** die zweiten Mischer (2) zum Betrieb bei einer zweiten Lokaloszillatorfrequenz ($\omega_{LO2}$) angeordnet sind, wobei die erste und zweite Lokaloszillatorfrequenz ($\omega_{LO1}$; $\omega_{LO2}$) separat auswählbar sind.

2.  Mischer zur Unterdrückung der Spiegelfrequenz nach Anspruch 1, bei welchem die Mehrphasen-Filter (15) bei einer Spiegelfrequenz der zweiten Mischer (2) eingestellt sind.

3.  Mischer zur Unterdrückung der Spiegelfrequenz nach Anspruch 1 oder 2, bei welchem das RF-Übertragungsband eine Mehrzahl an Nachbar-Übertragungskanälen enthält, welche bei einem Kanal-Zwischenabstand beabstandet sind, wobei die erste Mittenfrequenz (IF1) der ersten Mischer (1) derart ausgewählt ist, dass die Spiegelfrequenzen der ersten Mischer (1) innerhalb des Kanal-Zwischenabstandes neben einem ausgewählten Kanal sind.

4.  Mischer zur Unterdrückung der Spiegelfrequenz nach Anspruch 3, bei welchem die erste Mittenfrequenz (IF1) derart ausgewählt ist, dass die Spiegelfrequenzen im wesentlichen am Kanal-Zwischenabstand sind.

5.  Mischer zur Unterdrückung der Spiegelfrequenz nach Anspruch 4, bei welchem die Mehrphasen-Filter (15) bei einer Frequenz eingestellt sind, welche im wesentlichen gleich der doppelten zweiten Lokaloszillatorfrequenz ($\omega_{LO2}$) der zweiten Mischer (2) plus dem halben Kanal-Zwischenfrequenzabstand ist.

6.  Mischer zur Unterdrückung der Spiegelfrequenz nach einem der vorhergehenden Ansprüche, welcher Filter (16, 17) enthält, welche wirksam zwischen dem ersten Mischer (1) und dem Mehrphasen-Filter (15) angeordnet sind, um die ersten Quadratursignale ($I_{IF1}$, $Q_{IF1}$) zu filtern.

7.  Mischer zur Unterdrückung der Spiegelfrequenz nach Anspruch 6, bei welchem die Filter (16, 17) ein Tiefpass-Filter sind, welcher kleiner als von fünfter Ordnung ist.

8.  Mischer zur Unterdrückung der Spiegelfrequenz nach einem der vorhergehenden Ansprüche, bei welchem der Mehrphasen-Filter (15) ein symmetrisches RC-Netzwerk enthält.

9.  Mischer zur Unterdrückung der Spiegelfrequenz nach Anspruch 8, bei welchem das RC-Netzwerk aktive Schaltungselemente enthält, welche in einem ohmschen und/oder kapazitiven Modus betrieben werden.

10. Mischer zur Unterdrückung der Spiegelfrequenz nach Anspruch 9, bei welchem die Schaltungselemente elektronisch einstellbar sind, welches eine automatisch einstellbare oder automatisch steuerbare Mischerschaltung bereitstellt.

11. Empfänger zum Betrieb in einem Funkfrequenz(RF)-Übertragungsband, wobei der Empfänger einen Mischer zur Unterdrückung der Spiegelfrequenz nach einem der Ansprüche 1 bis 10 enthält.

12. Empfänger nach Anspruch 11, bei welchem der erste Mischer (1) einen einstellbaren ersten Lokaloszillator (18) enthält.

13. Empfänger nach Anspruch 11 oder 12, welcher auf einem einzelnen Halbleiterchip hergestellt ist, insbesondere ein komplementärer Metalloxyd-Halbleiter (CMOS) oder ein bipolarer CMOS(BiCMOS)-Halbleiterchip.

14. Funk-Kommunikationseinheit (20), insbesondere ein Funktelefon zum Betrieb in einem Funkkommunikationssystem, wie beispielsweise DECT (Digital Enhanced Cordless Telecommunications) oder GSM (Global Systems for Mobile Communications), mit einem Übertragungsmittel (22), einem Steuermittel zur Taktung und Synchronisation (23) und Informations- und Signalisierungs-Verarbeitungsmitteln (21, 24, 26 - 35), wobei das Übertragungsmittel (22) einen Empfänger nach einem der Ansprüche 11, 12 oder 13 enthält.

## Revendications

1. Mélangeur à réjection de fréquence d'image pour un récepteur radio pour un fonctionnement dans une bande de transmission de fréquence radio (RF), ledit mélangeur à réjection de fréquence d'image comprenant des premiers moyens (1) formant mélangeur agencés pour fonctionner à une première fréquence ($\omega_{LO1}$) d'oscillateur local pour une conversion vers le bas d'un signal d'entrée RF fournissant des premiers signaux en quadrature ($I_{IF1}$, $Q_{IF1}$) centrés à une première fréquence intermédiaire (IF1) et de telle sorte que des fréquences d'image desdits premiers moyens formant mélangeur sont dans ladite bande de transmission RF, et des deuxièmes moyens formant mélangeur (2) pour une conversion vers le haut desdits premiers signaux en quadrature fournissant des deuxièmes signaux en quadrature ($I_{IF2}$, $Q_{IF2}$) centrés à une deuxième fréquence intermédiaire (IF2) au-dessus de ladite première fréquence intermédiaire (IF1), et un moyen (15) formant filtre polyphasé agencé de manière opérationnelle entre lesdits premier et deuxième moyens formant mélangeurs (1 ; 2) pour fournir des premiers signaux en quadrature filtrés pour une conversion vers le haut par lesdits deuxièmes moyens (2) formant mélangeur, **caractérisé en ce que** lesdits deuxièmes moyens (2) formant mélangeur sont agencés pour fonctionner à une deuxième fréquence ($\omega_{LO2}$) d'oscillateur local, lesdites première et deuxième fréquences ($\omega_{LO1}$ ; $\omega_{LO2}$) d'oscillateur local pouvant être sélectionnées séparément.

2. Mélangeur à réjection de fréquence d'image selon la revendication 1, dans lequel lesdits moyens (15) formant filtre polyphasé sont accordés à une fréquence d'image desdits deuxièmes moyens (2) formant mélangeur.

3. Mélangeur à réjection de fréquence d'image selon la revendication 1 ou 2, dans lequel ladite bande de transmission RF comprend une pluralité de canaux de transmission adjacents espacés selon une distance d'espacement de canaux, ladite première fréquence intermédiaire (IF1) desdits premiers moyens formant mélangeur (1) étant sélectionnée de telle sorte que lesdites fréquences d'image desdits premiers moyens formant mélangeur (1) sont dans la distance d'espacement de canaux dans une position adjacente à un canal sélectionné.

4. Mélangeur à réjection de fréquence d'image selon la revendication 3, dans lequel ladite première fréquence intermédiaire (IF1) est sélectionnée de telle sorte que lesdites fréquences d'image sont sensiblement à la distance d'espacement de canaux.

5. Mélangeur à réjection de fréquence d'image selon la revendication 4, dans lequel lesdits moyens (15) formant filtre polyphasé sont accordés à une fréquence sensiblement égale au double de la deuxième fréquence locale ($\omega_{LO2}$) d'oscillateur desdits deuxièmes moyens formant mélangeur (2) plus la moitié de la distance de la fréquence d'espacement de canaux.

6. Mélangeur à réjection de fréquence d'image selon l'une quelconque des revendications précédentes, comprenant un moyen (16, 17) formant filtre agencé de manière opérationnelle entre lesdits premiers moyens (1) formant mélangeur et lesdits moyens (15) formant filtre polyphasé, pour filtrer lesdits premiers signaux en quatrature ($I_{IF1}$, $Q_{IF1}$).

7. Mélangeur à réjection de fréquence d'image selon la revendication 6, dans lequel lesdits moyens formant filtre (16, 17) sont des moyens formant filtre passe bas ayant un ordre inférieur à 5.

8. Mélangeur à réjection de fréquence d'image selon l'une quelconque des revendications précédentes, dans lequel lesdits moyens formant filtre polyphasé (15) comprennent un réseau RC équilibré.

9. Mélangeur à réjection de fréquence d'image selon la revendication 8, dans lequel ledit réseau RC comprend des éléments de circuit actifs actionnés dans un mode résistif et/ou capacitif.

10. Mélangeur à réjection de fréquence d'image selon la revendication 9, dans lequel lesdits éléments de circuit peuvent être accordés de manière électronique, fournissant un circuit formant mélangeur à capacité d'auto-accord ou d'auto-commande.

**11.** Récepteur pour fonctionner dans une bande de transmission radiofréquence (RF), ledit récepteur comprenant un mélangeur à réjection de fréquence d'image selon l'une quelconque des revendications 1 à 10.

**12.** Récepteur selon la revendication 11, dans lequel lesdits premiers moyens formant mélangeur (1) comprennent un premier oscillateur local (18) pouvant être accordé.

**13.** Récepteur selon la revendication 11 ou 12, fabriqué sur une seule puce à semiconducteur, en particulier une puce à semiconducteur métal oxyde complémentaire (CMOS) ou une puce à semiconducteur bipolaire CMOS (BiCMOS).

**14.** Unité (20) de communication radio, en particulier téléphone radio pour fonctionner dans un système de communication radio tel qu'un DECT (Digital Enhanced Cordless Telecommunications) ou un GSM (Global System for Mobile communications) comprenant un moyen (22) formant émetteur-récepteur, un moyen (23) de commande de cadençage et de synchronisation et un moyen (21, 24, 26 - 35) de traitement d'information et de signalisation, dans lequel ledit moyen (22) formant émetteur-récepteur comprend un récepteur selon l'une quelconque des revendications 11, 12 ou 13.

Fig. 1 (prior art)

Fig. 2 (prior art)

Fig. 5 (prior art)

Fig. 3

Fig. 4

Fig. 6

EP 0 948 129 B1